Europäisches Patentamt

European Patent Office

Office européen des brevets

(19)

(11) Numéro de publication: **0 140 774**
**B1**

(12) FASCICULE DE BREVET EUROPEEN

(45) Date de publication du fascicule du brevet:
01.06.88

(21) Numéro de dépôt: 84402028.9

(22) Date de dépôt: 09.10.84

(51) Int. Cl.⁴: **C 30 B 13/24**, C 30 B 29/60

(54) Procédé de fabrication d'un film semiconducteur monocristallin sur un support isolant.

(30) Priorité: 14.10.83 FR 8316396

(43) Date de publication de la demande:
08.05.85 Bulletin 85/19

(45) Mention de la délivrance du brevet:
01.06.88 Bulletin 88/22

(84) Etats contractants désignés:
DE GB IT NL

(56) Documents cités:
APPLIED PHYSICS LETTERS, vol. 41, no. 4, 15 août
1982, pages 346-347, American Institute of Physics; J.P.
COLINGE et al.: "Use of selective annealing for growing
very large grain silicon on insulator films"
Applied Physics Letters, 39(7) 1981, pages 561-563

(73) Titulaire: Alamome, Michel, 36 rue de la Pêcherie,
Voreppe (FR)
Titulaire: Bensahel, Daniel, 32 rue Lachman,
F-38000 Grenoble (FR)
Titulaire: Colinge, Jean-Pierre, 5 av. du Vercors,
F-38240 Meylan (FR)

(72) Inventeur: Alamome, Michel, 36 rue de la Pêcherie,
Voreppe (FR)
Inventeur: Bensahel, Daniel, 32 rue Lachman,
F-38000 Grenoble (FR)
Inventeur: Colinge, Jean-Pierre, 5 av. du Vercors,
F-38240 Meylan (FR)

(74) Mandataire: Mongrédien, André et al, c/o
BREVATOME 25, rue de Ponthieu, F-75008 Paris (FR)

**Description**

La présente invention a pour objet un procédé de fabrication d'un film semiconducteur monocristallin sur un support isolant. Elle trouve une application dans la fabrication de circuits intégrés et notamment de circuits à grande rapidité de fonctionnement, de circuits résistant aux radiations ionisantes, ou de circuits fonctionnant sous haute tension.

L'un des procédés utilisés, pour fabriquer un film semiconducteur monocristallin sur un support isolant, consiste à déposer, sur le support, un film semiconducteur amorphe ou polycristallin, par exemple de silicium, puis à balayer la surface du film au moyen d'un faisceau laser ponctuel permettant de fondre localement le film; en se refroidissant la région du film ainsi fondue se recristallise sous forme monocristalline.

Le balayage du film est réalisé de façon continue avec un «spot» laser, de petite dimension, que l'on déplace rectilignement d'une extrémité à l'autre du film, par exemple suivant une direction X. A chaque fois que le «spot» laser se trouve à l'une des extrémités du film, ce spot est légèrement déplacé, perpendiculairement à la direction X, ce qui permet de soumettre tout le film semiconducteur à l'action du faisceau laser et donc de recristalliser le film en totalité.

Ce procédé, très largement employé, ne permet de recristalliser sous forme monocristalline que de petits îlots de matériaux semiconducteurs (50 x 500 μm²). L'emploi de ce procédé pour fabriquer des films semiconducteurs de grande dimension conduit à l'obtention de gros cristaux orientés dans toutes les directions. La limite entre deux cristaux adjacents est appelée joint de grains. La présence de ces joints de grains est très gênante pour fabriquer des transistors, notamment du type MOS, sur le film semiconducteur recristallisé.

Un procédé récent a permis de réaliser des cristaux longs et minces (20 μm x 5 mm) et de contrôler la position ds joints de grains. Ce procédé consiste à réaliser sur le film semiconducteur plusieurs bandes parallèles antiréfléchissantes puis à balayer, comme précédemment, le film semiconducteur au moyen d'un faisceau laser. Le balayage est alors réalisé parallèlement aux bandes antiréfléchissantes, ce balayage étant effectué plusieurs fois.

Ce procédé a notamment été décrit dans un article de «Applied Physics Letters», vol. 41, du 15 août 1982 de J.P. Colinge et al., intitulé «Use of selective annealing for growing very large grain silicon on insulator films», pages 346–347.

Ce procédé permet, certes de diminuer considérablement le nombre de joints de grains, mais il ne permet pas de tous les supprimer.

La présente invention a justement pour objet un procédé de fabrication de films semiconducteurs monocristallins sur un support isolant ne présentant aucun joint de grains; ce procédé permettant d'obtenir un film semiconducteur monocristallin continu est basé sur l'emploi de bandes parallèles antiréfléchissantes.

De façon plus précise, l'invention a pour objet un procédé de fabrication d'un film semiconducteur monocristallin sur un support isolant dans lequel:

  – on dépose, sur un support isolant réfractaire, un film semiconducteur,

  – on réalise, sur le film semiconducteur, plusieurs bandes parallèles antiréfléchissantes,

  – on balaye l'ensemble par le rayonnement d'un faisceau laser continu d'énergie suffisante pour fondre localement le film semiconducteur et provoquer une recristallisation du film semiconducteur,

  – on élimine les bandes antiréfléchissantes, caractérisé en ce qu'il consiste à:

  – soumettre l'une des extrémités du film semiconducteur à l'action d'un rayonnement lumineux en forme de raie orientée perpendiculairement aux bandes antiréfléchissantes, cette raie étant obtenue en balayant rapidement, à une fréquence supérieure à 10 kHz, le film semiconducteur, selon une direction perpendiculaire aux bandes antiréfléchissantes, au moyen du faisceau laser continu,

  – déplacer le support et/ou la raie parallèlement aux bandes antiréfléchissantes, de façon à balayer en une seule fois la totalité du film semiconducteur et à recristalliser ainsi le film sous forme monocristalline.

L'utilisation combinée d'un rayonnement en forme de raie d'énergie, obtenue au moyen d'un faisceau laser, permet d'obtenir des films semiconducteurs de grandes dimensions (de l'ordre de 5 x 5 mm²) ne présentant aucun joint de grains. Par ailleurs, le fait de balayer en une seule fois la totalité du film semiconducteur permet de recristalliser celui-ci de façon plus rapide que dans les procédés de l'art antérieur.

Ce procédé de fabrication s'applique avantageusement à la réalisation, sur un support de préférence en oxyde de silicium, d'un film de silicium.

Selon un mode préféré de réalisation de l'invention, les bandes antiréfléchissantes sont réalisées en nitrure de silicium.

D'autres caractéristiques et avantages de l'invention ressortiront mieux de la description qui va suivre, donnée à titre illustratif mais nullement limitatif, en référence aux figures annexées, sur lesquelles:

  – les figures 1 et 2 représentent schématiquement les différentes étapes du procédé de fabrication conformément à l'invention, la figure 1 étant une vue en coupe et la figure 2 une vue de dessus, et

  – la figure 3 représente schématiquement un dispositif permettant de recristalliser, conformément à l'invention, un film semiconducteur.

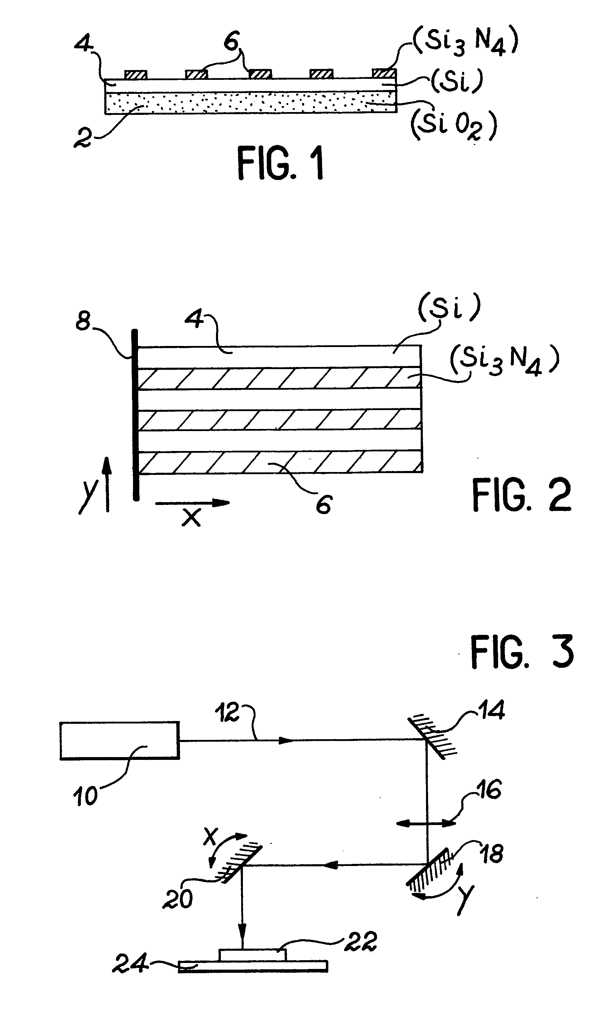

Le procédé de fabrication conformément à l'invention consiste tout d'abord, comme représenté sur la figure 1, à déposer sur un support isolant réfractaire 2, par exemple en oxyde de silicium, un film semiconducteur 4. Ce film semiconducteur réalisé de préférence en silicium, peut être déposé par la technique de dépôt chimique en phase vapeur, à basse pression ou non. Ce film peut présenter une épaisseur comprise entre (500 angströms) 50 nm et quelqus microns suivant l'application ultérieure de ce film.

Sur ce film semiconducteur 4, on réalise ensuite, par les procédés classiques de photolithographie (masquage et gravure) plusieurs bandes parallèles antiréfléchissantes 6. Ces bandes antiréfléchissantes 6, présentant par exemple une épaisseur de (400 Å) 40 nm, sont réalisées de préférence en nitrure de silicium. Ces bandes 6, pour un film semiconducteur de 5 × 5 mm², peuvent présenter une largeur de quelques microns et être espacées les unes des autres de quelques dizaines de microns.

L'étape suivante du procédé consiste, comme représenté sur la figure 2 qui représente une vue de dessus de la figure 1, à soumettre l'une des extrémités du film semi-conducteur à l'action d'un rayonnement en forme de raie ou de pinceau d'énergie 8. Ce rayonnement ou cette raie d'énergie 3, située perpendiculairement aux bandes antiréfléchissantes 6, présente une énergie suffisante pour fondre localement le film semiconducteur 4. Le balayage du film semiconducteur par la raie ou pinceau d'énergie 8, selon une direction X parallèle aux bandes antiréfléchissantes 6, permet de recristalliser le film semiconducteur sous forme monocristalline.

Le balayage du film semiconducteur peut être réalisé, soit en déplaçant le pinceau d'énergie 8 parallèlement aux bandes 6, le support 2, donc le film 4, étant maintenus fixes, soit en déplaçant le support, donc le film, parallèlement aux bandes 6, en maintenant le pinceau d'énergie 8 fixe. Ce balayage se fait par exemple à une vitesse de l'ordre de 5 mm/s.

La dernière étape du procédé, non représentée sur les figures, consiste à éliminer les bandes antiréfléchissantes 6 par exemple par un procédé d'attaque chimique. Lorsque ces bandes sont réalisées en nitrure de silicium, on peut utiliser de l'hexafluorure de soufre comme agent d'attaque.

La raie ou pinceau d'énergie 8 est une raie ou un pinceau lumineux.

Cette raie de lumière est obtenue en balayant très rapidement le film semiconducteur, selon une direction Y, perpendiculaire aux bandes antiréfléchissantes 6, au moyen d'un faisceau laser continue, ce balayage pouvant être réalisé au moyen d'un déflecteur acousto-optique ou d'un système électromécanique.

Sur la figure 3, on a représenté un système électro-mécanique permettant de réaliser une raie lumineuse et d'effectuer le déplacement de cette raie parallèlement aux bandes antiréfléchissantes. Ce dispositif comprend une source laser continue 10, par exemple à argon et ayant une puissance comprise entre 10 W et 25 W, émettant un faisceau lumineux 12 qui est, après réflexion sur un miroir 14, focalisé par une lentille 16 sur le film semiconducteur à recristalliser. Ce faisceau focalisé peut ensuite être dévié à l'aide de deux miroirs tournants 18 et 20 permettant d'effectuer, respectivement, un balayage très rapide du film semiconducteur selon la direction Y, perpendiculaire aux bandes antiréfléchissantes, et un balayage lent parallèlement aux bandes antiréfléchissantes, c'est-à-dire suivant la direction X. La commande des miroirs tournants 18 et 20 se fait par tout moyen connu par exemple à l'aide de moteurs asservis.

La vitesse de balayage selon une direction perpendiculaire aux bandes antiréfléchissantes est supérieure à 10 kHz, par exemple comprise entre 50 kHz et 200 kHz.

Le système décrit ci-dessus (figure 3) permet de balayer la totalité du film semiconducteur, à l'aide de la raie d'énergie 8, en déplaçant celle-ci parallèlement aux bandes antiréfléchissantes 6, et en maintenant le support 2, donc le film, fixe. Mais comme on l'a dit précédemment, la raie d'énergie 8 peut être maintenue fixe et c'est alors le support 2 que l'on déplace suivant la direction parallèle aux bandes antiréfléchissantes 6. Ce type de balayage peut être réalisé en déposant l'échantillon à recristalliser, portant la référence 22, sur une table à translation XY 24 (figure 3), la translation étant alors effectuée uniquement suivant la direction X parallèle aux bandes antiréfléchissantes; dans ce cas, le miroir tournant 18 doit être bien entendu supprimé.

L'emploi de bandes antiréfléchissantes associé au déplacement d'une raie d'énergie et/ou du support sur lequel est déposé le film semiconducteur permet d'obtenir, en un seul balayage, un film continu monocristallin, c'est-à-dire un film dépourvu de joints de grains. Des études, notamment par attaque à la potasse, ont permis de montrer que le film semiconducteur, réalisé par le procédé de l'invention ne présentait effectivement aucun joint de grains.

Le procédé de l'invention permet de fabriquer des films semiconducteurs monocristallins, notamment de silicium, de 5 × 5 mm² sur un support isolant pouvant être avantageusement utilisé pour la fabrication de circuits intégrés MOS.

**Revendications**

1. Procédé de fabrication d'un film semiconducteur monocristallin sur un support isolant dans lequel:
   – on dépose, sur un support isolant réfractaire (2), un film semiconducteur (4),
   – on réalise, sur le film semiconducteur (4), plusieurs bandes parallèles antiréfléchissantes (6),
   – on balaye l'ensemble par le rayonnement d'un faisceau laser continu d'énergie suffisante pour fondre localement le film semiconducteur et provoquer une recristallisation du film semiconducteur,
   – on élimine les bandes antiréfléchissantes (6), caractérisé en ce qu'il consiste à:
   – soumettre l'une des extrémités du film semiconducteur (4) à l'action d'un rayonnement lumineux en forme de raie (8) orientée perpendiculairement aux bandes antiréfléchissantes (6), en balayant rapidement, à une fréquence supérieure à 10 kHz, le film semiconducteur (4) selon une direction (Y) perpendiculaire aux bandes antiréfléchissantes (6), au moyen du faisceau laser continu (12),
   – déplacer le support (2) et/ou la raie (8) parallèlement aux bandes antiréfléchissantes (6), de façon à balayer en une seule fois la totalité du film semiconducteur (4) et à recristalliser ainsi le film sous forme monocristalline.

2. Procédé de fabrication selon la revendication 1, caractérisé en ce que le film semiconducteur (4) est un film de silicium.

3. Procédé de fabrication selon la revendication 1 ou 2, caractérisé en ce que les bandes antiréfléchissantes (6) sont réalisées en nitrure de silicium.

4. Procédé de fabrication selon l'une quelconque des revendications 1 à 3, caractérisé en ce que le support isolant (2) est de l'oxyde de silicium.

**Patentansprüche**

1. Verfahren zur Herstellung einer einkristallinen Schicht aus Halbleitermaterial auf einem isolierenden Substrat:
– man bringt auf einem feuerfesten, isolierenden Substrat (2) eine Halbleitermaterialschicht (4) auf,
– man stellt auf der Halbleitermaterialschicht (4) mehrere parallele, reflexionsfreie Streifen (6) her,
– man tastet die Gesamtheit mit der Strahlung eines kontinuierlichen Laserbündels ausreichender Energie ab, um örtlich die Halbleitermaterialschicht zu schmelzen und eine erneute Kristallisation der Halbleitermaterialschicht hervorzurufen,
– man entfernt die reflexionsfreien Streifen (6), dadurch gekennzeichnet, daß es darin besteht:
– eines der Enden der Halbleitermaterialschicht (4) der Wirkung einer Lichtstrahlung in der Form eines Strichs (8), der senkrecht zu den reflexionsfreien Streifen (6) ausgerichtet ist, auszusetzen, indem die Halbleitermaterialschicht (4) bei einer Frequenz oberhalb von 10 kHz in einer zu den reflexionsfreien Streifen (6) senkrechten Richtung mittels eines kontinuierlichen Laserbündels (12) abgetastet wird,
– das Substrat (2) und/oder den zu den reflexionsfreien Streifen (6) parallelen Strich (8) so zu bewegen, daß mit einem einzigen Mal die Gesamtheit der Halbleitermaterialschicht (4) abgetastet wird und somit die Schicht in monokristalliner Form erneut kristallisiert.

2. Herstellungsverfahren nach Anspruch 1, dadurch gekennzeichnet, daß die Halbleitermaterialschicht (4) eine Siliciumschicht ist.

3. Herstellungsverfahren nach Anspruch 1 oder 2, dadurch gekennzeichnet, daß die reflexionsfreien Streifen (6) aus Siliciumnitrid hergestellt sind.

4. Herstellungsverfahren nach irgendeinem der Ansprüche 1 bis 3, dadurch gekennzeichnet, daß das isolierende Substrat (2) aus Siliciumoxid ist.

**Claims**

1. Process for the manufacture of a monocrystalline semiconductor film on an insulating support, in which:
– a semiconductor film (4) is deposited on a refractory insulating support (2),
– a number of parallel nonreflective bands (6) are produced on the semiconductor film (4),
– the assembly is scanned using the radiation of a continuous laser beam of sufficient energy to melt the semiconductor film locally and to cause a recrystallization of the semiconductor film, and
– the nonreflective bands (6) are removed, characterized in that it consists in:
– subjecting one of the ends of the semiconductor film (4) to the action of a luminous radiation in the form of a ray (8) directed perpendicularly to the nonreflective bands (6), by rapidly scanning, at a frequency higher than 10 kHz, the semiconductor film (4) in a direction (Y) perpendicular to the nonreflective bands (6), by means of the continuous laser beam (12), and
– moving the support (2) and/or the ray (8) in parallel with the nonreflective bands (6) so as to scan the whole of the semiconductor film (4) in a single operation and to thus recrystallize the film in a monocrystalline form.

2. Process of manufacture according to Claim 1, characterized in that the semiconductor film (4) is a silicon film.

3. Process of manufacture according to Claim 1 or 2, characterized in that the nonreflective bands (6) are made of silicon nitride.

4. Process of manufacture according to any one of Claims 1 to 3, characterized in that the insulating support (2) is silicon oxide.

0 140 774

4        6                    (Si₃N₄)
                             (Si)

2                            (SiO₂)

FIG. 1

8        4              (Si)
                        (Si₃N₄)

y

x        6      FIG. 2

FIG. 3

12              14

10

16

x        18

20      y

22

24

5